# EUROPEAN PATENT APPLICATION

(11) **EP 1 975 953 A2**
(43) Date of publication of application: **01.10.2008**
(21) Application number: 08005884.5
(22) Date of filing: 27.03.2008
(51) Int. Cl.: H01G 9/20, H01L 31/18

(54) **Photoelectric conversion electrode, manufacturing method of the same, and dye-sensitized solar cell**

(30) Priority: 29.03.2007 JP 2007086264
(71) Applicant: TDK Corporation, Tokyo 103-8272 (JP)
(72) Inventor: Monden, Atsushi, Tokyo 103-8272 (JP); Handa, Tokuhiko, Tokyo 103-8272 (JP)
(74) Representative: Grünecker, Kinkeldey, Stockmair & Schwanhäusser Anwaltssozietät

(57) **Abstract**

There are disclosed a photoelectric conversion electrode having a large amount of a dye to be supported and an excellent dye replacement property and capability of improving a mechanical strength and a photoelectric conversion efficiency. In a photoelectric conversion electrode 11 according to the present invention, on a substrate 12 having a conductive surface 12a, an underlayer 13 containing a metal oxide and a porous metal oxide layer 14 including a metal oxide and a dye can be prepared by an electrolytic deposition process, and an electrolysis potential of the underlayer 13 is set to a potential or less of a flection point having a minimum potential among a plurality of flection points observed in a range of 0 to -1.5 V (vs. Ag/AgCl) in a current-potential profile during electrolytic deposition, whereby the underlayer is formed so that pointed crystal particles 13a of the metal oxide are piled up in a layer thickness direction.

## Description

### BACKGROUND OF THE INVENTION

### Field of the Invention

The present invention relates to a photoelectric conversion electrode, a manufacturing method of the photoelectric conversion electrode, and a dye-sensitized solar cell including the photoelectric conversion electrode.

### Description of the Related Art

A dye-sensitized solar cell published by Gratzel et al. in 1991 has especially received attention as an organic solar cell capable of realizing a conversion efficiency of 10% or more. In recent years, application, development and research of the solar cell have intensively been performed in various research organizations at home and abroad. This dye-sensitized solar cell has a basic structure in which a redox electrolyte is sandwiched between an electrode and a counter electrode disposed so as to face the electrode. As the electrode, there is used a porous titanium oxide electrode having an adsorbed sensitizing dye and provided on a transparent conductive film of a transparent glass substrate. The titanium oxide electrode is prepared by coating the transparent conductive film with a coating solution in which titanium oxide particles are suspended, and firing the film at a temperature of about 300 to 500°C to allow the resultant film to adsorb the sensitizing dye.

On the other hand, in this type of dye-sensitized solar cell, from an industrial viewpoint of productivity improvement, it has been demanded that an inexpensive and lightweight plastic substrate having flexibility be employed as a member to replace the transparent glass substrate. However, as described above, a high temperature firing process is required for preparing the titanium oxide electrode, so that it has been difficult to employ a plastic substrate having a poor thermal resistance with respect to the glass substrate.

To solve this problem, for example, in Non-Patent Document 1, a dye-sensitized solar cell is suggested in which an electrode constituted of a metal oxide film such as porous zinc oxide is formed of an electrolyte containing a metal salt such as zinc chloride by use of a cathode electrolytic deposition process as a low temperature electrochemical technique, whereby the dye is adsorbed on the electrode. According to this technique, the porous metal oxide electrode can be prepared by performing the cathode electrolytic deposition using the electrolyte, so that the above-mentioned high temperature firing process required for manufacturing the solar cell having the above titanium oxide electrode can be omitted. However, on the other hand, the metal oxide electrode is formed and then allowed to adsorb the dye, so that a sufficient amount of the sensitizing dye cannot be adsorbed by the resultant dye-supported metal oxide electrode. Therefore, the photoelectric conversion efficiency cannot sufficiently be improved.

Therefore, to increase an amount of the dye to be supported in a zinc oxide electrode, for example, in Non-Patent Document 2, a method is suggested in which the cathode electrolytic deposition is performed using a zinc nitrate bath including a water-soluble dye such as eosin-Y beforehand added thereto as a template dye, whereby the water-soluble dye is co-adsorbed to form a hybrid thin film of zinc oxide/eosin-Y. It is disclosed in Patent Document 1 that the cathode electrolytic deposition is performed using a zinc nitrate electrolyte including eosin-Y beforehand added thereto as the template dye, whereby a porous photoelectric conversion semiconductor layer including co-adsorbed eosin-Y and having a specific surface area of 1 to 100 m²/g is prepared on a conductive surface of SnO₂. However, contrary to expectation, the dye-supported zinc oxide electrode prepared by the cathode electrolytic deposition process in this manner has a poor sensitizing function of the co-adsorbed dye typified by eosin-Y, and the photoelectric conversion efficiency of a photoelectric conversion element using the electrode is not sufficient.

Therefore, to introduce a dye having an excellent sensitizing function into the porous zinc oxide electrode, a method is disclosed in Patent Document 2 in which the porous zinc oxide electrode prepared by co-adsorbing zinc oxide and eosin-Y onto a conductive surface of ITO is alkali-treated to once desorb the dye therefrom, and then a highly sensitive sensitizing dye is re-adsorbed. According to this technique, it has been expected that the zinc oxide electrode with a sufficient amount of the highly sensitive sensitizing dye supported thereon can be realized.

[Patent Document 1] Japanese Patent Application Laid-Open No. 2002-184476
[Patent Document 2] Japanese Patent Application Laid-Open No. 2004-006235
[Non-Patent Document 1] S. Peulon et al., J. Electrochem. Soc., 145, 864 (1998)
[Non-Patent Document 2] T. Yoshida et al., Electrochemistry, 70, 470 (2002)

However, in the above-mentioned conventional porous zinc oxide electrode which has co-adsorbed the template dye, it is remarkably difficult to sufficiently desorb the co-adsorbed template dye and re-adsorb the sufficient amount of the sensitizing dye. Therefore, when the porous zinc oxide electrode is used in the dye-sensitized solar cell, a photoelectric conversion efficiency (η) cannot sufficiently be raised. On the contrary, cell characteristics such as an open-circuit voltage (Voc), a short-circuit photoelectric current density (Jsc) and a fill factor (FF) are insufficient, and a higher performance is demanded so as to put the cell to practical use.

Moreover, in the above-mentioned conventional zinc oxide electrode with the dye supported thereon, owing to an internal stress generated by thermal contraction or the like accompanying a change.of an external environment or an external stress applied by a pressing or bending operation after manufacturing, local interface peeling and the like are generated. The electrode has such a low mechanical strength, and it has been demanded that mechanical reliability of the electrode be further improved in order to put the electrode to practical use.

### SUMMARY OF THE INVENTION

The present invention has been developed in view of such a situation, and an object is to provide a photoelectric conversion electrode including a metal oxide layer having an excellent dye replacement property and a large amount of a dye to be supported and capable of improving a mechanical strength and a photoelectric conversion efficiency, a manufacturing method of the electrode, and a dye-sensitized solar cell having excellent cell characteristics and a high mechanical strength.

To solve the above problem, the present inventors have intensively repeated researches, have eventually found that an underlayer having a specific structure can be formed to improve cell characteristics such as a mechanical strength and a photoelectric conversion efficiency, and have completed the present invention.

That is, a manufacturing method of a photoelectric conversion electrode according to the present invention comprises a step of preparing a substrate; a first electrolytic deposition step of forming, on the substrate, an underlayer containing a metal oxide by an electrolytic deposition process using an electrolyte containing at least a metal salt; and a second electrolytic deposition step of electrolytically depositing a metal oxide and co-adsorbing a template dye by an electrolytic deposition process using an electrolyte containing at least the metal salt and the template dye, to form a metal oxide layer on the underlayer, wherein the first electrolytic deposition step sets an electrolysis potential to a potential or less of a flection point having a minimum potential among a plurality of flection points observed in a range of 0 to -1.5 V (vs. Ag/AgCl) in a current-potential profile during electrolytic deposition to form the underlayer.

It is to be noted that in the present specification, "forming the underlayer on the substrate" includes a configuration in which an intermediate layer is provided on the substrate to form the underlayer on the intermediate layer in addition to a configuration in which the underlayer is directly provided on the substrate. Therefore, a specific configuration of the present invention includes both of a laminated structure in which the substrate directly comes in contact with the underlayer as in the former configuration and a laminated structure in which the substrate is disposed away from the underlayer via the intermediate layer as in the latter configuration.

As a result of measurement of a characteristic of a dye-sensitized solar cell including a counter electrode disposed so as to face the photoelectric conversion electrode having the above constitution and a charge transport layer provided between both of the electrodes, the present inventors have found that, as compared with a conventional technology, a mechanical strength is remarkably increased and that not only a photoelectric conversion efficiency but also any other cell characteristic are remarkably improved. Details of a functional mechanism which produces such an effect are not clarified yet, but are presumed as follows.

That is, in a crystal structure prepared by the above-mentioned conventional cathode electrolytic deposition process, zinc oxide epitaxially (pseudo lattice matching or lattice mismatching in this case) or substantially epitaxially grows from a conductive surface of a substrate of SnO₂, ITO or the like, and the structure includes regular crystals having anisotropy, and has poor adhesion and followability with respect to the conductive surface. Therefore, the mechanical strength against an internal stress and an external stress is small, and local peeling and the like are generated in an interface between the conductive surface and the metal oxide layer. As a result, it is presumed that an electron transport property is detracted, and a cell characteristic such as a high photoelectric conversion efficiency is not easily exerted.

On the other hand, in the present invention, on the above electrolytic deposition conditions, the underlayer in which pointed crystal particles of a metal oxide are piled up in a layer thickness direction is formed between the substrate and the metal oxide layer. In other words, unlike the conventional electrolytic deposition, the underlayer is formed in which the whole layer does not have a state of crystals substantially uniformly epitaxially grown externally from the conductive surface of the substrate, and the underlayer is porous, and has a large void ratio. Such an interfacial state between the underlayer and the other layer functions so as to raise the adhesion therebetween. In consequence, the adhesion and followability with respect to the conductive surface are improved, and a stress relaxing function with respect to the internal and external stresses is remarkably improved. As a result, it is presumed that the mechanical strength of the photoelectric conversion electrode is increased, and accordingly local interfacial peeling or the like on the conductive surface is suppressed, whereby a cell characteristic such as the photoelectric conversion efficiency is significantly improved.

Furthermore, as described above, the underlayer formed on the above electrolytic deposition conditions has a configuration in which the pointed metal oxide crystal particles are piled up in the layer thickness direction, and the underlayer has a minutely uneven (concavo-convex) surface and a large void ratio. Therefore, when the metal oxide layer is formed on the underlayer by the electrolytic deposition process using the electrolyte containing the metal salt and the template dye, the underlayer having such a configuration provides multiple nuclei (seeds) for crystal growth of the metal oxide layer, thereby forming the metal oxide layer of a specific structure having appropriate porosity to such an extent that the dye can physically move. Moreover, owing to a capillary function of the underlayer having the large void ratio, an amount of the template dye to be introduced into the metal oxide layer is increased. As a result, an amount of the dye to be supported on the metal oxide layer is increased, and a replacement property of the dye is improved, whereby the photoelectric conversion efficiency is significantly improved. Furthermore, it is presumed that cell characteristics such as an open-circuit voltage, a short-circuit photoelectric current density and a fill factor can remarkably be improved owing to the specific structure having the appropriate porosity of the layer. However, the function is not limited to this example.

More specifically, it is preferable that the first electrolytic deposition step arranges the substrate and a counter electrode in the electrolyte so that the substrate faces the counter electrode, and applies the electrolysis potential between the substrate and the counter electrode to form the underlayer. In this case, a photoelectric conversion electrode having an excellent mechanical strength can easily be manufactured with good reproducibility.

Furthermore, it is more preferable that the second electrolytic deposition step arranges the underlayer and the counter electrode in the electrolyte so that the underlayer faces the counter electrode, and applies a voltage of -0.8 to -1.2 V (vs. Ag/AgCl) between the underlayer and the counter electrode, whereby the metal oxide is electrolytically deposited on the underlayer, and the template dye is co-adsorbed to form the metal oxide layer. Such electrolysis conditions are used, whereby the photoelectric conversion electrode including the metal oxide layer having an excellent dye replacement property can more easily be manufactured with good reproducibility.

Furthermore, it is more preferable that the method further comprises: a dye desorption step of desorbing the template dye co-adsorbed on the metal oxide layer; and a dye re-adsorption step of allowing the metal oxide layer to support a second dye different from the template dye. In this case, even a sensitizing dye difficult to use, depending on the electrolysis conditions of the electrolytic deposition step, can be introduced into the metal oxide layer in the re-adsorption step, so that the availability of materials (process tolerance) can be broadened, and productivity and economical efficiency can further be improved.

Moreover, a photoelectric conversion electrode according to the present invention comprises a substrate; an underlayer formed on the substrate and containing a metal oxide; and a metal oxide layer formed on the underlayer and including the metal oxide and a dye, wherein the underlayer has a structure in which pointed crystal particles of the metal oxide are piled up in a layer thickness direction. It is to be noted that it is preferable in the present invention that the pointed crystal particles of the metal oxide are irregularly piled up in the layer thickness direction. Here, "piled up" means a state in which the whole underlayer is not most densely filled (is not close-packed) with the crystal particles of the metal oxide.

Furthermore, it is more preferable that the metal oxide layer has a plurality of bump-like protrusions formed so as to radially protrude from the surface of the underlayer. The metal oxide layer has such a special structure, whereby denseness of a film structure of the metal oxide layer is appropriately relaxed. In consequence, porosity is obtained to such an extent that the dye (molecules) can physically move. As a result, an adsorption site area at a time when the dye is adsorbed increases, and the desorption of the co-adsorbed dye and re-adsorption can efficiently be performed. It is to be noted that as described later, the plurality of bump-like protrusions of zinc oxide according to the present invention are formed so that the protrusions individually grow so as to rise. On the other hand, in the conventional zinc oxide electrode having a high c-axis orientation, such bump-like protrusions are not formed. It has also been confirmed that the electrode of the present invention is significantly different in, for example, a sectional shape from the conventional electrode.

Furthermore, a dye-sensitized solar cell according to the present invention comprises the photoelectric conversion electrode of the present invention, a counter electrode disposed so as to face the photoelectric conversion electrode; and a charge transport layer disposed between the photoelectric conversion electrode and the counter electrode.

According to the photoelectric conversion electrode, the manufacturing method of the photoelectric conversion electrode and the dye-sensitized solar cell including the photoelectric conversion electrode of the present invention, a mechanical strength and a dye replacement property can be improved, and an amount of a dye to be supported can be increased, so that when this electrode is used as a photoelectric conversion element, a high photoelectric conversion efficiency can be realized, and cell characteristics such as an open-circuit voltage, a short-circuit photoelectric current density and a fill factor can be improved. Moreover, the porous metal oxide layer can be formed at a low temperature without any high temperature firing process, so that productivity and economical efficiency can be improved. In addition, a plastic substrate or the like having a poor thermal resistance as compared with a glass substrate can be applied as the substrate. Therefore, the availability of materials (process tolerance) can be broadened, and the productivity and economical efficiency can further be improved.

### BRIEF DESCRIPTION OF THE DRAWINGS

[0093]
FIG. 1 is a schematic sectional view schematically showing one embodiment of a photoelectric conversion electrode according to the present invention;
FIGS. 2A to 2C are step diagrams showing one example of a manufacturing method of the photoelectric conversion electrode according to the present invention;
FIG. 3 is a schematic sectional view schematically showing one embodiment of a dye-sensitized solar cell according to the present invention;
FIG. 4 is a graph showing a current-potential profile in a first electrolytic deposition step of a photoelectric conversion electrode according to Example 1;
FIG. 5 is a sectional SEM photograph of the photoelectric conversion electrode according to Example 1;
FIG. 6 is a sectional SEM photograph of the photoelectric conversion electrode according to Example 1;
FIG. 7 is a sectional SEM photograph of a photoelectric conversion electrode according to Comparative Example 1;
FIG. 8 is a sectional SEM photograph of the photoelectric conversion electrode according to Comparative Example 1;
FIG. 9 is a plane photograph of a photoelectric conversion electrode according to Example 2; and
FIG. 10 is a plane photograph of a photoelectric conversion electrode according to Comparative Example 2.

### DESCRIPTION OF THE PREFERRED EMBODIMENTS

Embodiments of the present invention will hereinafter be described. It is to be noted that the same element is denoted with the same reference numeral, and redundant description is omitted. Moreover, positional relations of top, bottom, left, right and the like are based on a positional relation shown in the drawings unless otherwise mentioned. Furthermore, a dimensional ratio of the drawing is not limited to a shown ratio. The following embodiments merely illustrate the present invention, and the present invention is not limited only to the embodiments.

### (First Embodiment)

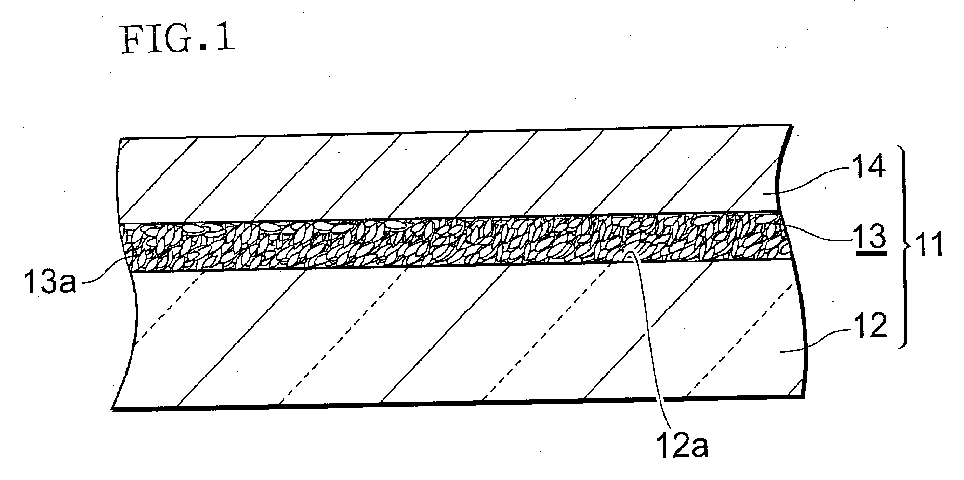

FIG. 1 is a schematic sectional view schematically showing one embodiment of a photoelectric conversion electrode according to the present invention. In a photoelectric conversion electrode 11, an underlayer 13 including zinc oxide as a metal oxide, and a porous metal oxide layer 14 including zinc oxide as the metal oxide and a sensitizing dye (the dye) are laminated in this order on a substrate 12 having a conductive surface 12a.

There is not any special restriction on a type or a dimensional shape of the substrate 12 as long as the substrate can support at least the metal oxide layer 14. For example, a plate-like or sheet-like substrate is preferably used. In addition to a glass substrate, examples of the substrate include a plastic substrate of polyethylene terephthalate, polyethylene, polypropylene or polystyrene, a metal substrate, an alloy substrate, a ceramic substrate, and a laminated substrate thereof. The substrate 12 preferably has an optical transparency, and more preferably has an excellent optical transparency property in a visible light range. Furthermore, the substrate 12 preferably has flexibility. In this case, various configurations of structures can be provided taking advantage of the flexibility.

Moreover, there is not any special restriction on a technique for imparting conductivity to the surface of the substrate 12 to form the conductive surface 12a, and examples of the technique include a method using the substrate 12 having the conductivity, and a method to form a transparent conductive film on the substrate 12 as in a conductive PET film. There is not any special restriction on the latter transparent conductive film, but it is preferable to use FTO obtained by doping SnO₂ with fluorine, in addition to ITO, SnO₂ and InO₃. There is not any special restriction on a method for forming such a transparent conductive film, and a known technique such as an evaporation process, a CVD process, a spray process, a spin coat process or an immersion process can be applied. A thickness of the film can appropriately be set.

The underlayer 13 has a porous structure in which pointed zinc oxide crystal particles 13a are piled up in a layer thickness direction and which is substantially constituted of zinc oxide. Here, "substantially constituted of zinc oxide" means that zinc oxide is a main component. The layer may include zinc oxide having a composition ratio different from that of strictly stoichiometric zinc oxide (ZnO), and stoichiometry of the layer is not limited to ZnO (ZnₓO_{y}, in which x = 1, y = 1). The layer may contain, for example, zinc hydroxide as an unavoidable component, a slight amount of unavoidable impurities such as another metal salt and hydrate and the like (this also applies to the metal oxide layer 14 described later). Moreover, to reform the underlayer 13, titanium oxide, tungsten oxide, barium titanate, tin oxide, indium oxide, lead oxide and the like may be included to such an extent that a function and an effect of the present invention are not disturbed. It is to be noted that stoichiometry of "zinc oxide" in the present invention is not limited to ZnO (ZnₓO_{y}, in which x = 1, y = 1).

The crystal particles 13a in the underlayer 13 have a pointed particle shape, and constitute a so-called structure having a convex-like shape or an acute angle. There is not any special restriction on the shape. For example, a needle-like shape, an oval sphere-like shape, a pyramid-like shape or a conical shape may be employed. In addition, an indefinite shape of a structure in which a part of a spherical shape, a rectangular shape, a prismatic shape or a columnar shape is deformed to form a convex-like shape or an acute angle may be employed, and any other configuration may be employed. That is, "pointed" means a concept containing these shapes.

There is not any special restriction on a particle size of the crystal particles 13a in the underlayer 13, but a major axis and a minor axis of each particle are in a range of preferably about 10 to 500 nm, more preferably 30 to 300 nm.

Moreover, there is not any special restriction on a film thickness of the underlayer 13, but the thickness is preferably 0.1 to 5 µm, more preferably 1 to 3 µm. When this film thickness is less than 0.1 µm, there is a tendency that an effect of suppressing interfacial peeling of the metal oxide layer decreases. When the thickness exceeds 5 µm, an electric resistance increases, and hence a cell characteristic tends to lower. When the underlayer 13 having a thickness of, for example, 0.2 µm, about several to several hundred pointed crystal particles 13a are accumulated in the layer thickness direction and piled up (deposited, multiplied, stacked), whereby the underlayer 13 having a large void ratio and high flexibility is constituted.

It is to be noted that the underlayer 13 preferably has an optical transparency, and further preferably has conductivity. Moreover, a material of the underlayer 13 is not especially limited only to zinc oxide of the present embodiment. In addition to zinc oxide of the present embodiment, for example, the metal oxide for use in the above-mentioned transparent conductive film or the like may preferably be used.

The metal oxide layer 14 is a composite structure in which a sensitizing dye is supported on a porous structure substantially constituted of zinc oxide. It is preferable that this metal oxide layer 14 has a plurality of bump-like protrusions 14a formed so as to radially protrude (grow) externally (upwardly in the drawing) from the side of the conductive surface 12a of the substrate 12. Such a peculiar structure is provided, whereby an adsorption site area of the dye to be co-adsorbed increases. Moreover, the co-adsorbed dye and a second dye can efficiently be desorbed and re-adsorbed, so that a dye replacement property improves. A property of this metal oxide layer 14 can be observed by sectional SEM photography, sectional TEM photography or the like as described later.

There is not any special restriction on the sensitizing dye (the dye) to be supported on the metal oxide layer 14, and the dye may be a water-soluble dye, a water-insoluble dye or an oil-soluble dye. From a viewpoint that an amount of the dye to be supported be increased, the dye preferably has anchor group(s) which interacts with zinc oxide. Specific examples of the dye include xanthein-based dyes such as eosin-Y, coumarin-based dyes, triphenyl methane-based dyes, cyanine-based dyes, merocyanine-based dyes, phthalocyanine-based dyes, porphyrin-based dyes, and polypyridine metal complex dyes. In addition, the examples include ruthenium bipyridium-based dyes, azo dyes, quinone-based dyes, quinonimine-based dyes, quinacridone-based dyes, squarium-based dyes, perylene-based dyes, indigo-based dyes, and naphthalocyanine-based dyes, which have carboxylic group(s), sulfonic group(s) or phosphoric group(s).

Moreover, there is not any special restriction on a film thickness of the metal oxide layer 14, but the thickness is preferably 1 to 15 µm, more preferably 2 to 10 µm. When this film thickness is less than 1 µm, the dye is not sufficiently supported, whereby a short-circuit photoelectric current density sometimes disadvantageously tends to lower. When the thickness exceeds 15 µm, there are disadvantages that the film strength becomes insufficient or that a fill factor lowers.

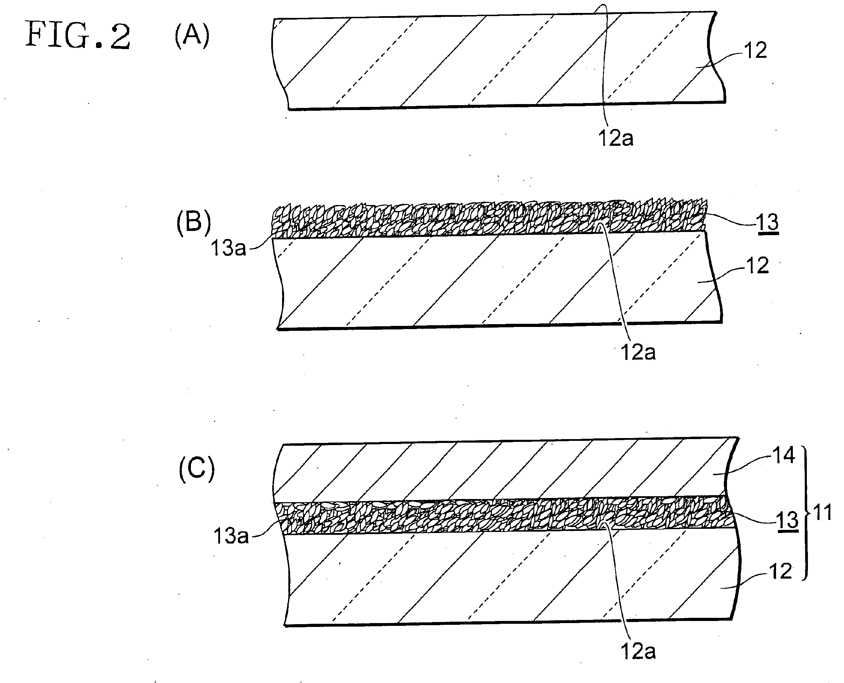

One example of a manufacturing method of the photoelectric conversion electrode 11 of the first embodiment will hereinafter be described. FIGS. 2A to 2C are step diagrams showing that the photoelectric conversion electrode 11 is manufactured. The photoelectric conversion electrode 11 is prepared by a step (FIG. 2A) of preparing the substrate 12, a first electrolytic deposition step (FIG. 2B) of forming the underlayer 13 on the substrate 12 by a cathode electrolytic deposition process, and a second electrolytic deposition step (FIG. 2C) of forming the metal oxide layer 14 by the cathode electrolytic deposition process.

### <Surface Treatment of Substrate>

First, conductivity is imparted to one surface of the substrate 12 by the above-mentioned appropriate method to form the conductive surface 12a (FIG. 2A). It is to be noted that when the substrate 12 beforehand having the conductivity, for example, a metal plate is used as the substrate 12, the step of imparting the conductivity is unnecessary. Subsequently, prior to formation of the underlayer 13, the conductive surface 12a of the substrate 12 is subjected to an appropriate surface modification treatment, if necessary. Specific examples of the treatment include a known surface treatment such as a degreasing treatment with a surfactant, an organic solvent or an alkaline aqueous solution, a mechanical polishing treatment, an immersion treatment in an aqueous solution, a preliminary electrolysis treatment with an electrolyte, a washing treatment and a drying treatment.

### <First Electrolytic Deposition Step>

Subsequently, the underlayer 13 is formed on the conductive surface 12a of the substrate 12 by a cathode electrolytic deposition process. Specifically, the conductive surface 12a of the substrate 12 is disposed so as to face a counter electrode in an electrolyte including zinc salt, and a predetermined voltage is applied between the conductive surface 12a of the substrate 12 and the counter electrode by use of a reference electrode according to an ordinary process, whereby zinc oxide is deposited or piled up on the conductive surface 12a of the substrate 12 to form the underlayer.

As the electrolyte for use herein, an aqueous solution containing zinc salt and having a pH of about 4 to 9 is preferably used. A small amount of an organic solvent may be added to this electrolyte. There is not any special restriction on zinc salt as long as the zinc salt is a zinc ion source capable of supplying zinc ions in the solution. Examples of the zinc salt for preferable use include zinc halides such as zinc chloride, zinc bromide and zinc iodide, zinc nitrate, zinc sulfate, zinc acetate, zinc peroxide, zinc phosphate, zinc pyrophosphate, and zinc carbonate. A zinc ion concentration in the electrolyte is preferably 0.5 to 100 mM, more preferably 2 to 50 mM. It is to be noted that when the electrolyte includes zinc halide, an electrolytic deposition reaction of zinc oxide due to reduction of dissolved oxygen in the aqueous solution is promoted, so that oxygen is, for example, bubbled to preferably sufficiently introduce required oxygen.
Moreover, a bath temperature of the electrolyte can be set to a broad range in consideration of the thermal resistance of the substrate 12 for use, and the temperature is usually preferably 0 to 100°C, more preferably about 20 to 90°C.

There is not any special restriction on an electrolysis method, and a diode or triode system may be applied. As an energization system, a direct current may be supplied, or a constant potential electrolysis process or a pulse electrolysis process may be used. As the counter electrode, platinum, zinc, gold, silver, graphite or the like may be used according to an ordinary process. Among them, zinc or platinum is preferably used.

A reduction electrolysis potential is set to a potential of a flection point having a minimum potential or less among a plurality of flection points observed in a scanning range of 0 to -1.5 V (vs. Ag/AgCl) in a current-potential profile during electrolytic deposition. At such an electrolysis potential, zinc oxide is deposited to form the underlayer 13 having a peculiar structure in which the pointed crystal particles 13a are piled up in a layer thickness direction. On the other hand, when zinc oxide is deposited and formed at a potential above this electrolysis potential, in general, numerous zinc oxide crystals epitaxially grow into a hexagonal columnar shape to form a layer (the underlayer 13) substantially uniformly grown externally from the conductive surface of a substrate. Therefore, it is difficult to form the peculiar structure in which the pointed crystal particles 13a are piled up in the layer thickness direction as in the present invention.

Here, the current-potential profile during the electrolytic deposition means a "current (A/cm²)-potential (V vs. Ag/AgCl) curve" obtained in a case where the electrolytic deposition is performed while changing an applied potential. It is preferable to acquire this current-potential profile with respect to a sample beforehand prepared before the underlayer 13 is actually formed.

The underlayer 13 obtained on the above conditions is usually a porous structure in which the pointed zinc oxide crystal particles 13a are piled up in the layer thickness direction and which has a large void ratio, depending on electrolytic deposition conditions of the layer. Afterward, if necessary, the underlayer 13 is subjected to a known post-treatment such as washing, drying and the like according to an ordinary process.

### <Second Electrolytic Deposition Step>

Subsequently, the metal oxide layer 14 is formed on the underlayer 13 by a cathode electrolytic deposition process. Specifically, the underlayer 13 is disposed so as to face a counter electrode in an electrolyte including zinc salt and a template dye, and a predetermined voltage is applied between the underlayer 13 and the counter electrode by use of a reference electrode according to an ordinary process, whereby a metal oxide is electrolytically deposited on the underlayer 13, and the template dye is co-adsorbed to electrolytically deposit and form the metal oxide layer 14 (FIG. 2C).

As the electrolyte, an electrolyte prepared by adding the template dye to be co-adsorbed to the electrolyte described above in the first electrolytic deposition step is preferably used. It is to be noted that an electrolysis method is similar to the above first electrolytic deposition step.

Moreover, a reduction electrolysis potential may appropriately be set in a range of -0.8 to -1.2 V (vs. Ag/AgCl), preferably -0.9 to -1.1 V (vs. Ag/AgCl). The reduction electrolysis potential is in this range, whereby the metal oxide layer 14 including a porous structure having an excellent dye replacement property and a large amount of the dye to be supported can effectively be formed. On the other hand, when the reduction electrolysis potential is above -0.8 V, the film becomes excessively dense, and there is a disadvantage that the amount of the dye to be supported runs short. When the potential is less than -1.2 V, there are disadvantages that the metal oxide becomes more metallic to lower an electric property and that an adhesion of the film deteriorates.

The dye for use as the template dye in this second electrolytic deposition step is co-adsorbed by the cathode electrolytic deposition process, so that the dye is preferably dissolved or dispersed in the electrolyte. When an aqueous solution containing zinc salt and having a pH of about 4 to 9 is used as the electrolyte, a water-soluble dye is preferable.

Specifically, from a viewpoint that the amount of the dye to be supported be increased, the template dye preferably has anchor group(s) which interacts with the surface of zinc oxide, and is preferably a water-soluble dye having anchor group(s) such as a carboxyl group, a sulfonic group or a phosphoric group. More specific examples of the dye include xanthein-based dyes of eosin-Y or the like, coumarin-based dyes, triphenyl methane-based dyes, cyanine-based dyes, merocyanine-based dyes, phthalocyanine-based dyes, porphyrin-based dyes, and polypyridine metal complex dyes.

Moreover, a concentration of the dye in the electrolyte may appropriately be set in a range of 50 to 500 µM, but is more preferably 70 to 300 µM. When this dye concentration is less than 50 µM, the film becomes denser than necessary, and there is a disadvantage that the amount of the dye to be supported runs short. When the concentration exceeds 500 µM, the density of the film lowers more than necessary, and electron conductivity lowers, so that the photoelectric conversion efficiency lowers, and a film strength of the metal oxide layer 14 tends to lower.

The metal oxide layer 14 obtained on the above conditions is usually a structure having a plurality of bump-like protrusions formed so that crystals of zinc oxide protrude radially from the surface of the substrate 12, and having appropriate denseness and porosity. Moreover, the plurality of bump-like protrusions define an uneven (concavo-convex) shape of the surface of the layer. Afterward, the metal oxide layer 14 is subjected to a known post-treatment such as washing, drying and the like according to'an ordinary process, if necessary.

The photoelectric conversion electrode 11 obtained in this manner may be used as a photoelectric conversion electrode having excellent mechanical strength and dye replacement property and a large amount of the dye to be supported, or as a precursor of the electrode. It is preferable that the photoelectric conversion electrode 11 is subjected to the following dye desorption treatment and dye re-adsorption treatment in order to further improve the photoelectric conversion efficiency of the electrode.

### <Dye Desorption Step>

Here, first of all, the template dye co-adsorbed on the metal oxide layer 14 of the photoelectric conversion electrode 11 is desorbed. Specific examples of this technique include a simple technique to immerse and treat the photoelectric conversion electrode 11 including the template dye in an alkaline aqueous solution containing of sodium hydroxide, potassium hydroxide or the like and having a pH of about 9 to 13. As this alkaline aqueous solution, a heretofore known solution may be used, and can appropriately be selected in accordance with a type of the template dye to be desorbed.

Moreover, in this desorption treatment, it is preferable to desorb preferably 80% or more, more preferably 90% or more of the template dye in the metal oxide layer 14. It is to be noted that there is not any special restriction on an upper limit of a desorption ratio of the template dye, but the upper limit is substantially 99%, because it is actually difficult to completely desorb the template dye incorporated in zinc oxide crystals. The desorption treatment is preferably performed while heating, because a desorption efficiency can effectively be raised.

Afterward, a greater part of the template dye is desorbed from the photoelectric conversion electrode 11 obtained by performing a known post-treatment such as washing, drying and the like according to an ordinary process if necessary, and the electrode 11 may be used as the precursor of the photoelectric conversion electrode having the excellent mechanical strength and dye replacement property and a large latent amount of the dye to be supported.

### <Dye Re-adsorption Step>

As described above, a desired sensitizing dye (the second dye) can be re-adsorbed on the metal oxide layer 14 obtained by the desorption treatment of the template dye. Specific examples of this step include a simple technique to immerse the substrate 12 having the metal oxide layer 14 obtained by the desorption treatment of the template dye in a dye-containing solution including the second dye to be re-adsorbed. A solvent of the dye-containing solution for use here can appropriately be selected from known solvents such as water, an ethanol-based solvent and a ketone-based solvent in accordance with solubility, compatibility or the like with respect to the desired sensitizing dye.

As the sensitizing dye to be re-adsorbed, a dye having a desired light absorption band and absorption spectrum can appropriately be selected in accordance with a property required for application to the photoelectric conversion element. According to the treatment of this dye re-adsorption step, the template dye co-adsorbed by the electrolytic deposition step during the formation of the metal oxide layer 14 can be replaced with a dye different from the template dye, and a sensitizing dye more highly sensitive than the template dye is used as the dye, whereby a cell characteristic such as the photoelectric conversion efficiency can be improved.

Here, unlike the template dye beforehand co-adsorbed, the sensitizing dye is not limited in accordance with the type of the electrolyte. Besides the above-mentioned water-soluble dye, for example, a solvent for use in the dye-containing solution is appropriately selected, whereby a water-insoluble and/or oil-soluble dye can be used. In addition to the water-soluble dye exemplified above as the template dye to be co-adsorbed, more specific examples of the sensitizing dye include ruthenium bipyridium-based dyes, azo dyes, quinone-based dyes, quinonimine-based dyes, quinacridone-based dyes, squarium-based dyes, cyanine-based dyes, merocyanine-based dyes, triphenyl methane-based dyes, xanthein-based dyes, porphyrin-based dyes, coumarin-based dyes, phthalocyanine-based dyes, perylene-based dyes, indigo-based dyes, and naphthalocyanine-based dyes. From a viewpoint that the dye be re-adsorbed by the metal oxide layer 14, it is more preferable that the dye has anchor group(s) such as a carboxyl group, a sulfonic group or a phosphoric group which interacts with the surface of zinc oxide.

The photoelectric conversion electrode 11 subsequently subjected to a known post-treatment such as washing, drying and the like according to an ordinary process if necessary is a composite structure in which the sensitizing dye is adsorbed by the surface of zinc oxide, and can preferably be used as a discrete electrode having a high mechanical strength, a large amount of the dye to be supported and further improved photoelectric conversion efficiency, or as the precursor of the electrode.

### (Second Embodiment)

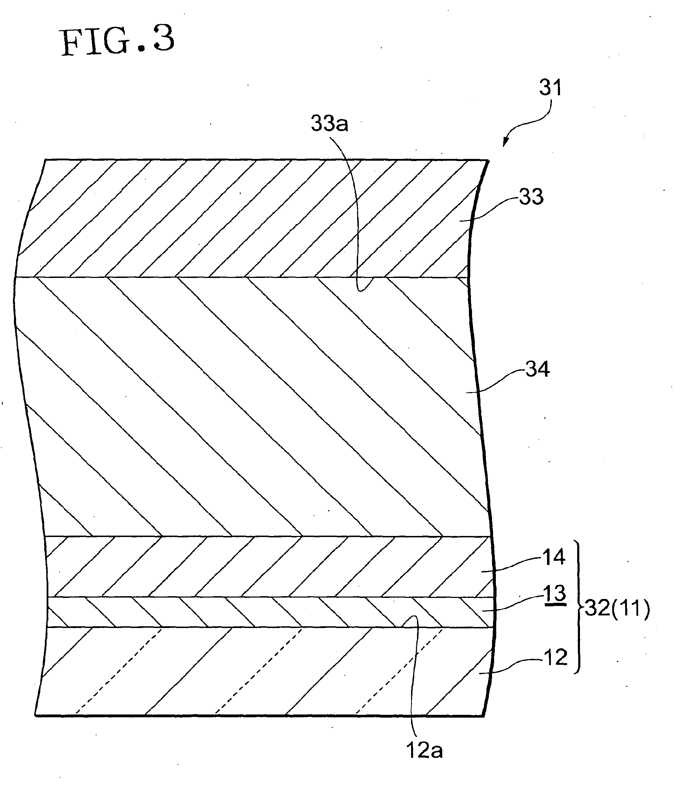

FIG. 3 is a schematic sectional view schematically showing one embodiment of a dye-sensitized solar cell according to the present invention. A dye-sensitized solar cell 31 includes an electrode 11 described above in the first embodiment, as a photoelectric conversion electrode 32, and has a counter electrode 33 disposed so as to face the photoelectric conversion electrode 32, and a charge transport layer 34 disposed between the photoelectric conversion electrode 32 and the counter electrode 33.

The counter electrode 33 is disposed so that a conductive surface 33a of the counter electrode faces a metal oxide layer 14. As the counter electrode 33, a known electrode may appropriately be employed. For example, in the same manner as in a substrate 12 of the photoelectric conversion electrode 11 having a conductive surface 12a, there may be used an electrode having a conductive film on a transparent substrate, an electrode in which a film of a metal, carbon, a conductive polymer or the like is further formed on the conductive film of the transparent substrate or the like.

As the charge transport layer 34, a layer usually for use in a cell, a solar cell or the like may appropriately be used. For example, there may be used a redox electrolyte, a semi-solid electrolyte obtained by gelating the redox electrolyte or a film formed of a p-type semiconductor solid hole transport material.

Here, when the solution-based or semi-solid-based charge transport layer 34 is used, according to an ordinary process, the photoelectric conversion electrode 32 is disposed away from the counter electrode 33 via a spacer (not shown) or the like, and a periphery of the arranged electrodes is sealed to define a sealed space, followed by introducing an electrolyte into the space. Examples of a typical electrolyte of the dye-sensitized solar cell include an acetonitrile solution, an ethylene carbonate solution, a propylene carbonate solution, and a mixed solution thereof, which include iodine and iodide or bromine and bromide. Furthermore, a concentration of the electrolyte, various additives and the like can appropriately be set and selected in accordance with a required performance. For example, halides, an ammonium compound or the like may be added.

### [Examples]

The present invention will hereinafter be described in detail with respect to examples, but the present invention is not limited to these examples.

### (Example 1)

### <Advance Measurement of Current-Potential Profile>

Prior to preparation of a photoelectric conversion electrode, a current-potential profile during electrolytic deposition of an underlayer was measured. First, as a substrate, a transparent glass substrate (trade name A110U80 : manufactured by Asahi Glass Fabric Co., Ltd.) having a transparent conductive film of SnO₂ doped with fluorine was prepared, and a lead wire was attached to one end of the transparent conductive film, and connected to an operation pole of a stabilizing power source. Subsequently, the surface of the transparent conductive film and a lead wire connecting portion were covered with a masking tape having an opening with a size of 5 mm x 20 mm, whereby the transparent conductive film was exposed only to the opening to prepare a film-forming portion.

Then, a lead wire was connected to a zinc plate as a counter electrode, and connected to an Ag/AgCl electrode as a reference electrode for reference. Afterward, the film-forming portion of the transparent conductive film of the transparent glass substrate was disposed so as to face the counter electrode, and the reference electrode was disposed in a polypropylene-made container.

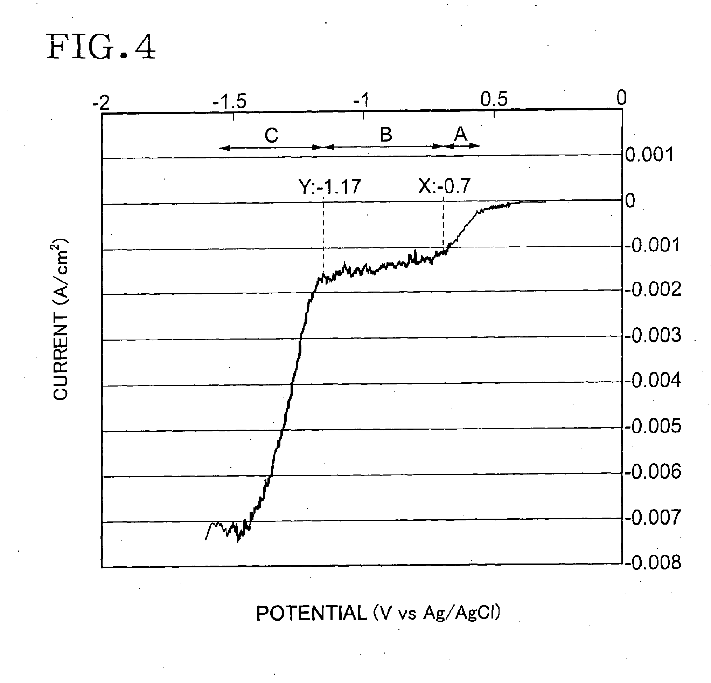

Subsequently, an aqueous solution of potassium chloride and zinc chloride was put into the container so that concentrations of them was 0.1 M and 0.005 M, respectively, to prepare an electrolyte, and a bath temperature of the electrolyte was held at 70°C. Then, a range of 0 to -1.5 V (vs. Ag/AgCl) was scanned with the stabilizing power source, and a current value-a voltage value at that time were monitored. FIG. 4 is a graph showing the current-potential profile obtained in this manner.

As shown in FIG. 4, a first flection point X and a second flection point Y were observed in -0.70 V (vs. Ag/AgCl) and -1.17 V (vs. Ag/AgCl), respectively. As shown in the drawing, regions A, B and C were separated via the flection points, and tilts of curves of the regions were calculated. As a result, the region A had a tilt of 6.9 (mA/[V•cm²]), the region B had a tilt of 1.1 (mA/[V•cm²]), and the region C had a tilt of 22 (mA/[V•m ²] ).

### <Preparation of Photoelectric Conversion Electrode>

The same substrate as that for the above preliminary measurement was separately prepared, and cathode electrolytic deposition was performed on the same conditions as those for the above preliminary measurement except that a reduction electrolysis potential of -1.2 V (vs. Ag/AgCl) was applied for five minutes. The electrolysis potential was a potential or less of the flection point Y indicating a flection point having a minimum potential of the profile shown in FIG. 4 (a first electrolytic deposition step), and zinc oxide was deposited in the film-forming portion of the transparent conductive film to form an underlayer.

Furthermore, eosin-Y as a template dye was added to an electrolyte similar to that used in the first electrolytic deposition step so as to obtain a dye concentration of 0.1 mM, thereby preparing the solution (an electrolyte). Then, using the solution (an electrolyte), a reduction electrolysis potential of -1.0 V (vs. Ag/AgCl) was applied to perform cathode electrolytic deposition for 30 minutes (a second electrolytic deposition step), whereby a porous metal oxide layer as a composite structure of zinc oxide and eosin-Y was formed on the underlayer to obtain a photoelectric conversion electrode.

Subsequently, the resultant photoelectric conversion electrode was washed, dried, and then immersed in a KOH aqueous solution to desorb eosin-Y as the co-adsorbed dye in the metal oxide layer, followed by performing again washing and drying treatments.

On the other hand, as a dye-containing solution containing a second dye, a t-BuOH/CH₃CN solution at a volume ratio of 1:1 containing 0.5 mM of sensitizing dye (D149: manufactured by Mitsubishi Paper Mills, Ltd.) was prepared, and the electrode from which eosin-Y was desorbed was immersed in this dye-containing solution to re-adsorb the sensitizing dye D149 on the metal oxide layer. Afterward, the washing and drying treatments were performed with an acetonitrile solution to obtain a photoelectric conversion electrode of Example 1.

### <Preparation of Dye-Sensitized Solar Cell>

A dye-sensitized solar cell having a structure similar to that of the dye-sensitized solar cell 31 shown in FIG. 3 was prepared by the following procedure by use of a photoelectric conversion electrode prepared in the same manner as in the above procedure. Here, the photoelectric conversion electrode 11 of Example 1 was used as a photoelectric conversion electrode 32, and as a counter electrode 33, an electrode was used in which a Pt thin film having a thickness of 100 nm was evaporated and formed on a transparent glass substrate (trade name A110U80 : manufactured by Asahi Glass Fabric Co., Ltd.) of a transparent conductive film of SnO₂ doped with fluorine. Then, the photoelectric conversion electrode 32 was brought into close contact with the counter electrode 33 via a spacer having a thickness of 70 µm, and a periphery around these electrodes was sealed with an epoxy resin to define a sealed space, followed by introducing an electrolyte as a charge transport layer 34 into the space. In consequence, dye-sensitized solar cells were prepared. As the electrolyte, a mixed solution of ethylene carbonate and acetonitrile at a volume ratio of 80:20 containing 0.04 M of iodine and 0.4 M of tetrapropyl ammonium iodide (TPAI) was used.

### (Example 2)

A dye-sensitized solar cell of Example 2 was prepared in the same manner as in Example 1 except that a photoelectric conversion electrode prepared in the same manner as in Example 1 was subjected to a thermal shock test as described later to prepare a photoelectric conversion electrode of Example 2, and this photoelectric conversion electrode of Example 2 was used as a photoelectric conversion electrode 32.

### (Comparative Example 1)

A photoelectric conversion electrode of Comparative Example 1 was prepared in the same manner as in Example 1 except that an electrolysis potential in a first electrolytic deposition step was set to -0.8 V (vs. Ag/AgCl) which was a potential of a flection point Y having a minimum potential or more.

A dye-sensitized solar cell of Comparative Example 1 was prepared in the same manner as in Example 1 except that a photoelectric conversion electrode prepared in the same manner as in Comparative Example 1 was used as a photoelectric conversion electrode 32.

### (Comparative Example 2)

A dye-sensitized solar cell of Comparative Example 2 was prepared in the same manner as in Example 1 except that a photoelectric conversion electrode prepared in the same manner as in Comparative Example 1 was subjected to a thermal shock test as described later to prepare a photoelectric conversion electrode of Comparative Example 2, and this photoelectric conversion electrode of Comparative Example 2 was used as a photoelectric conversion electrode 32.

### (Comparative Example 3)

A photoelectric conversion electrode of Comparative Example 3 was prepared in the same manner as in Example 1 except that an electrolysis potential in a first electrolytic deposition step was set to -0.6 V (vs.
Ag/AgCl) which was a potential of a flection point Y having a minimum potential or more.

A dye-sensitized solar cell of Comparative Example 3 was prepared in the same manner as in Example 1 except that a photoelectric conversion electrode prepared in the same manner as in Comparative Example 3 was used as a photoelectric conversion electrode 32.

### [Sectional Structure Evaluation]

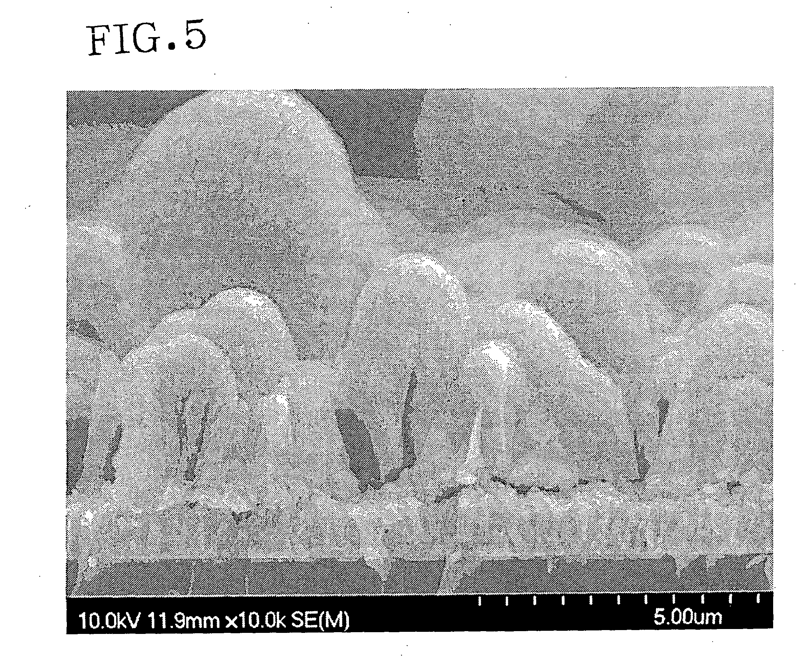

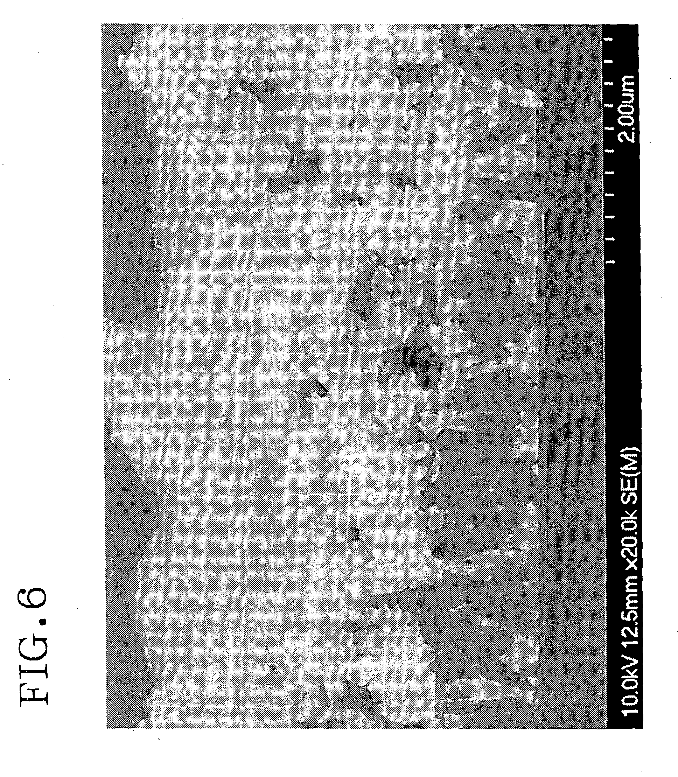

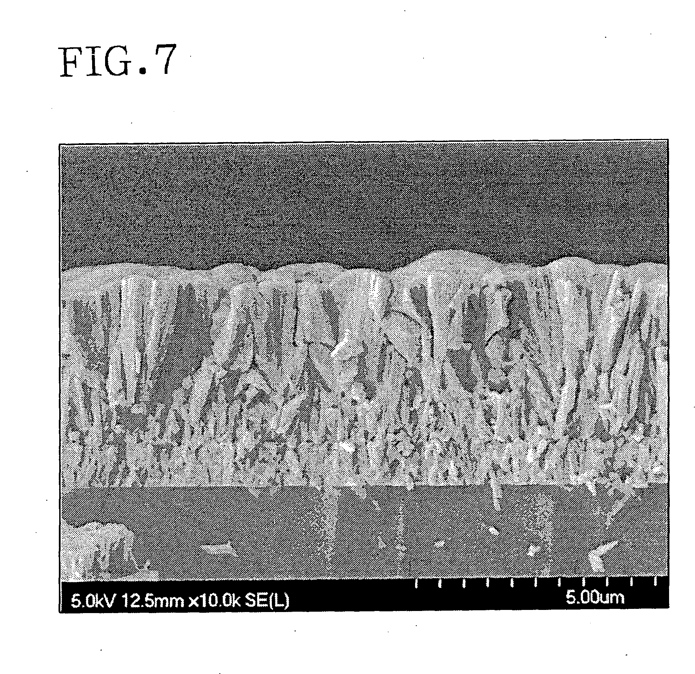

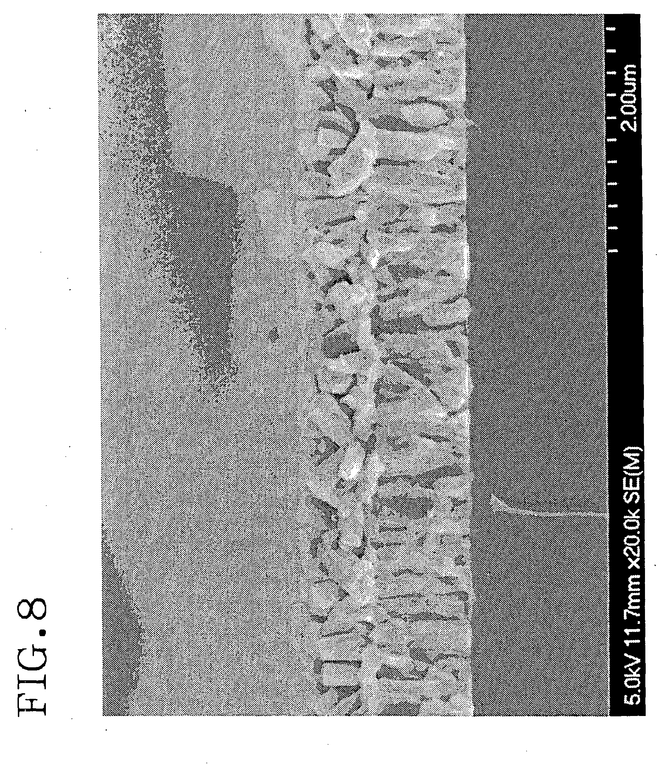

Sections of the photoelectric conversion electrodes of Example 1 and Comparative Example 1 were observed with an electron microscope. FIG. 5 is a sectional SEM photograph of the photoelectric conversion electrode according to Example 1, and FIG. 6 is a sectional SEM photograph of a substrate having an underlayer on a conductive surface thereof, before a metal oxide layer was formed in the photoelectric conversion electrode of Example 1. FIG. 7 is a sectional SEM photograph of the photoelectric conversion electrode according to Comparative Example 1, and FIG. 8 is a sectional SEM photograph of a substrate having an underlayer on a conductive surface thereof, before a metal oxide layer was formed in the photoelectric conversion electrode of Comparative Example 1.

It has been found from FIGS. 5 and 6 that the underlayer included in the photoelectric conversion electrode of Example 1 is a porous structure constituted by irregularly piling up a plurality of pointed crystal particles of zinc oxide having a size of about 50 to 200 nm in a layer thickness direction, and the porous structure has a remarkably large void ratio owing to the numerous crystal particles. It has also been found that the metal oxide layer included in the photoelectric conversion electrode of Example 1 is a structure having a plurality of raised portions referred to as bump-like protrusions prepared so that zinc oxide protrudes radially from the side of the substrate, and the plurality of bump-like protrusions form an uneven surface.

On the other hand, it has been found from FIGS. 7 and 8 that the underlayer included in the photoelectric conversion electrode of Comparative Example 1 is a structure in which numerous hexagonally columnar crystals of zinc oxide substantially uniformly epitaxially grow externally from the conductive surface of the substrate. It has also been found that the metal oxide layer included in the photoelectric conversion electrode of Comparative Example 1 is a structure in which substantially rectangular zinc oxide crystals epitaxially grow so as to substantially uniformly extend externally from the conductive surface of the substrate, and the substantially rectangular zinc oxide crystals form a substantially smooth surface.

It is to be noted that in the photoelectric conversion electrode of Comparative Example 3, the underlayer and the metal oxide layer largely peeled from the conductive surface of the substrate, so that sectional SEM observation was not performed.

### [Appearance Evaluation]

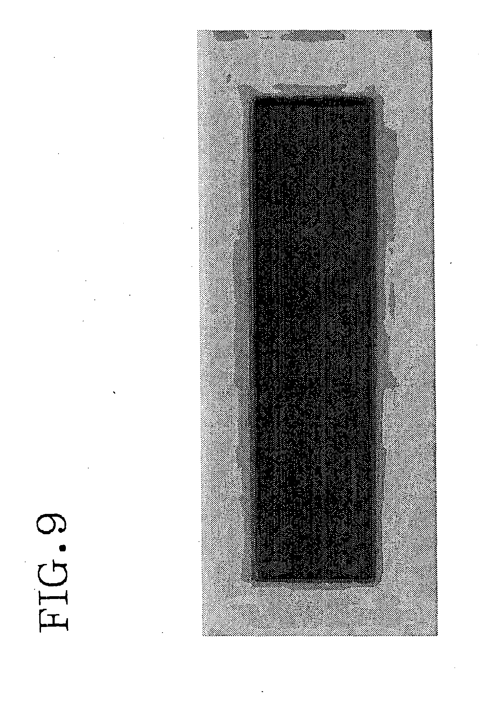

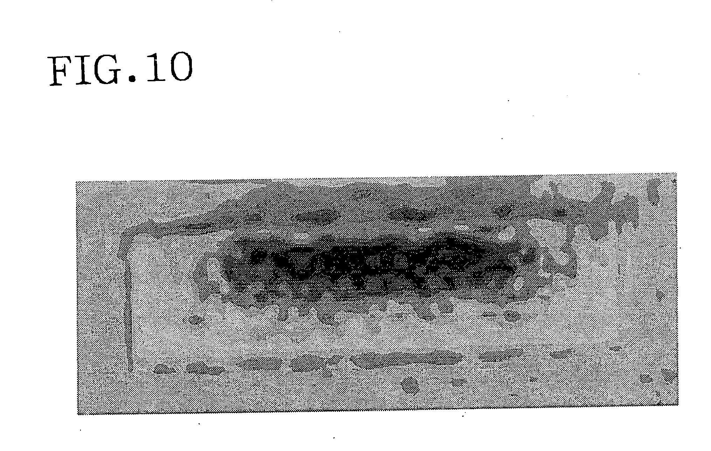

Appearances of the photoelectric conversion electrodes of Example 2 and Comparative Example 2 were visually observed. FIG. 9 is a plane photograph of an appearance of the photoelectric conversion electrode according to Example 2 taken with a digital camera, and FIG. 10 is a plane photograph of an appearance of the photoelectric conversion electrode according to Comparative Example 2 taken with the digital camera.

Here, to obtain the photoelectric conversion electrodes of Example 2 and Comparative Example 2, the photoelectric conversion electrodes prepared in the same manner as in Example 1 and Comparative Example 1 were subjected to the thermal shock test. In the thermal shock test, two types of constant temperature chambers including a high temperature chamber and a low temperature chamber are prepared, and the electrodes are kept alternately in the constant temperature chambers. It is to be noted that conditions for carrying out the thermal shock test were set to a temperature of 85°C in the high temperature chamber, a temperature of -40°C in the low temperature chamber, a time of 30 minutes for leaving the electrodes to stand in the constant temperature chambers, and a movement time of one minute or less between the constant temperature chambers. An operation of leaving the electrode to stand in each chamber was regarded as one cycle, and 700 cycles in total were performed.

It has been confirmed from FIG. 9 that the photoelectric conversion electrode of Example 2 subjected to the thermal shock test has a sufficient adhesion between the metal oxide layer and the conductive surface of the substrate, and any change is not seen from a state before the test. On the other hand, it has been confirmed from FIG. 10 that the photoelectric conversion electrode of Comparative Example 2 subjected to the thermal shock test has a state in which the underlayer and the metal oxide layer largely peel from the conductive surface of the substrate.

### [Cell Evaluation]

As cell characteristics of the dye-sensitized solar cells according to Examples 1, 2 and Comparative Examples 1 to 3, a photoelectric conversion efficiency (η), an open-circuit voltage (Voc), a short-circuit photoelectric current density (Jsc) and a fill factor (FF) were measured by use of a solar simulator with AM-1.5 (1000 W/m²). These measurement results are shown in Table 1.

**[Table 1]**

| | Reduction potential V(vs,Ag/AgCl) | short-circuit photoelectric current density Jsc(mA/cm²) | Open-circuit voltage Voc (V) | Fill factor FF | Conversion efficiency η(%) | Thermal shock test |
|---|---|---|---|---|---|---|
| Example 1 | -1.2 | 12.5 | 0.67 | 0.61 | 5.11 | None |
| Example 2 | | 11.8 | 0.64 | 0.62 | 4.68 | Performed |
| Comparative Example 1 | -0.8 | 9.2 | 0.60 | 0.52 | 2.87 | None |
| Comparative Example 2 | | 0.9 | 0.55 | 0.62 | 0.31 | Performed |
| Comparative Example 3 | -0.6 | 2.4 | 0.41 | 0.25 | 0.25 | None |

It has been confirmed from the results shown in Table 1 that the dye-sensitized solar cells using the photoelectric conversion electrodes of Examples 1 and 2 in which the electrolysis potential in the first electrolytic deposition step for forming the underlayer was set to a range of the present invention have remarkably excellent cell characteristics in any of the photoelectric conversion efficiency (η), the open-circuit voltage (Voc), the short-circuit photoelectric current density (Jsc) and the fill factor (FF) (above all, the photoelectric conversion efficiency (η), the open-circuit voltage (Voc) and the short-circuit photoelectric current density (Jsc)).

Moreover, in view of fluctuation widths before and after carrying out the thermal shock test, it has been found that in the dye-sensitized solar cells of Examples 1 and 2, mechanical strengths are remarkably improved, and performance deterioration of the cell characteristics is suppressed as compared with the dye-sensitized solar cells of Comparative Examples 1 and 2. In consequence, it is presumed that the underlayer in which the pointed crystal particles are irregularly piled up in the layer thickness direction relaxes thermal contraction (stress) generated during the thermal shock test, and suppresses local interface peeling and the like on the conductive surface.

It is to be noted that as described above, the present invention is not limited to the above embodiments and examples, and can appropriately be modified within the scope of the present invention.

As described above, according to a photoelectric conversion electrode, a manufacturing method of the electrode and a dye-sensitized solar cell of the present invention, a high mechanical strength and a high photoelectric conversion efficiency can be realized, and performances of cell characteristics can be improved. Furthermore, the electrode and the cell can easily be manufactured with good reproducibility. In addition, productivity and economical efficiency can be improved, so that the present invention can broadly and effectively be used in a general electrode for a photoelectric conversion element, electronic and electric materials and devices including the electrode, and various apparatuses, equipments and systems including these materials and devices.

[0000] The present application is based on Japanese priority application No. 2007-086264 filed on March 29, 2007, the entire contents of which are hereby incorporated by reference.

## Claims

1. A manufacturing method of a photoelectric conversion electrode comprising:
a step of preparing a substrate;
a first electrolytic deposition step of forming, on the substrate, an underlayer containing a metal oxide by an electrolytic deposition process using an electrolyte containing at least a metal salt; and
a second electrolytic deposition step of electrolytically depositing a metal oxide and co-adsorbing a template dye by an electrolytic deposition process using an electrolyte containing at least the metal salt and the template dye, to form a metal oxide layer on the underlayer,
wherein the first electrolytic deposition step sets an electrolysis potential to a potential or less of a flection point having a minimum potential among a plurality of flection points observed in a range of 0 to -1.5 V (vs. Ag/AgCl) in a current-potential profile during electrolytic deposition.

2. The manufacturing method of the photoelectric conversion electrode according to claim 1, wherein the first electrolytic deposition step arranges the substrate and a counter electrode in the electrolyte so that the substrate faces the counter electrode, and applies the electrolysis potential between the substrate and the counter electrode to form the underlayer.

3. The manufacturing method of the photoelectric conversion electrode according to claim 1 or 2, wherein the second electrolytic deposition step arranges the underlayer and the counter electrode in the electrolyte so that the underlayer faces the counter electrode, and applies a voltage of -0.8 to -1.2 V (vs. Ag/AgCl) between the underlayer and the counter electrode, whereby the metal oxide is electrolytically deposited on the underlayer, and the template dye is co-adsorbed to form the metal oxide layer.

4. The manufacturing method of the photoelectric conversion electrode according to claim 1, which further comprises:
a dye desorption step of desorbing the template dye co-adsorbed on the metal oxide layer; and
a dye re-adsorption step of allowing the metal oxide layer to support a second dye different from the template dye.

5. A photoelectric conversion electrode comprising:
a substrate;
an underlayer formed on the substrate and containing a metal oxide; and
a metal oxide layer formed on the underlayer and including the metal oxide and a dye,
wherein the underlayer has a structure in which pointed crystal particles of the metal oxide are piled up in a layer thickness direction.

6. The photoelectric conversion electrode according to claim 5, wherein the metal oxide layer has a plurality of bump-like protrusions formed so as to radially protrude from the side of the underlayer.

7. A dye-sensitized solar cell comprising:
a photoelectric conversion electrode including a substrate, an underlayer formed on the substrate and containing a metal oxide, and a metal oxide layer formed on the underlayer and including a metal oxide and a dye;
a counter electrode disposed so as to face the photoelectric conversion electrode; and
a charge transport layer disposed between the photoelectric conversion electrode and the counter electrode,
wherein the underlayer has a structure in which pointed crystal particles of the metal oxide are piled up in a layer thickness direction.
